# EUROPEAN PATENT APPLICATION

(11) **EP 2 098 619 A1**
(43) Date of publication of application: **09.09.2009**
(21) Application number: 09153595.5
(22) Date of filing: 25.02.2009
(51) Int. Cl.: C30B 15/10, C30B 35/00

(54) **Crucible holding member and method for producing the same**

(30) Priority: 26.02.2008 JP 2008044673
(71) Applicant: Ibiden Co., Ltd., Ogaki-shi, Gifu 503-8604 (JP)
(72) Inventor: Kato, Hideki, Ogaki Gifu (JP); Shikano, Haruhide, Ogaki Gifu (JP); Ando, Tomoyuki, Ogaki Gifu (JP); Yasuda, Masahiro, Ogaki Gifu (JP)
(74) Representative: HOFFMANN EITLE

(57) **Abstract**

A crucible holding member for holding a quartz crucible for containing a silicon melt is provided. The crucible holding member includes: a mesh body formed by weaving a plurality of strands, each including a plurality of carbon fibers; and a matrix filled in the interstices between the carbon fibers. The mesh body has a triaxial weave structure including: a plurality of longitudinal strands aligned in a same plane as a central axis of the mesh body; a plurality of first strands aligned in a first direction inclined at a first angle with respect to the central axis; and a plurality of second strands aligned in a second direction inclined at second angle same as the first angle with respect to the central axis. The first direction is opposite to the second direction with respect to the central axis.

## Description

### CROSS-REFERENCE TO RELATED APPLICATION

This application claims priority from Japanese Patent Application No. 2008-044673, filed on February 26, 2008, the entire subject matter of which is incorporated herein by reference.

### BACKGROUND OF THE INVENTION

### Field of the Invention

The present invention relates to a crucible holding member for holding a quartz crucible used in a silicon single crystal pulling.

### Description of the Related Art

A carbon material has heretofore been widely used in a silicon single crystal pulling apparatus, for the reasons that the carbon material has high heat resistance and high thermal shock properties, and that the carbon material hardly contaminates silicon. In particular, an isotropic graphite material is hard to react with a reactive gas such as SiO generated in the apparatus due to its high density, and the reaction rate of the isotropic graphite material with SiO₂ as a material for a quartz crucible for containing a silicon melt is small. Accordingly, the isotropic graphite material has been used as a graphite crucible for holding the periphery of the quartz crucible.

In recent years, an increase in diameter of a silicon wafer has progressed in order to increase yield and improve productivity, and a 300-mm wafer has been becoming mainstream. The development of a wafer further increased in diameter exceeding 400 mm has also been advanced. With this increase in diameter of the silicon wafer, the size of the silicon single crystal pulling apparatus becomes large, so that the weight of the graphite crucible used in the pulling apparatus becomes extremely heavy, resulting in the difficulty of handling such as setting of the graphite crucible to the apparatus.

Further, a production process of the isotropic graphite material requires a press process under hydrostatic pressure, and requires a Cold Isostatic Press (CIP) apparatus having a size of about 1.5 times the diameter of the graphite product. The diameter of the conventional CIP apparatus is not enough for the isotropic graphite material as a large-size graphite crucible, so that a larger apparatus becomes necessary.

As a technique for producing the large-size graphite crucible without using the CIP apparatus, there has been proposed a technique including forming carbon fibers into a crucible form by a filament winding process, impregnating it with a resin or pitch as a matrix, and burning it to produce a crucible made of a carbon/carbon fiber composite, hereinafter referred to as a C/C composite (for example, see JP-A-10-152391 or JP-A-11-60373), and a technique including adhering carbon fiber cloth to a forming die, performing molding and curing to obtain a carbon fiber-reinforced plastic, and then, impregnating and burning it to produce a crucible made of a C/C composite (for example, see JP-A-10-245275), or the like.

In the silicon single crystal pulling apparatus, a single crystal ingot is prepared while melting silicon, so that it is necessary to heat the inside of the apparatus to a temperature equal to or higher than the melting point (1,420°C) of silicon. When silicon is melted, the graphite crucible and the quartz crucible inserted therein are softened to cause close contact with each other.

The coefficient of thermal expansion of quartz glass is 0.6×10⁻⁶/°C, and that of the C/C composite is generally equivalent thereto. Accordingly, when the apparatus is cooled after completion of pulling of the single crystal ingot and the silicon melt is almost removed, both are cooled without being strongly restricted with each other.

However, when the silicon melt coagulates by a trouble such as a power failure immediately after the pulling is initiated, silicon has the property of expanding (a volume expansion of about 9.6%) with coagulation. This acts as the function of enlarging the quartz crucible and the graphite crucible.

In the case of the apparatus for pulling a small-diameter single crystal ingot, even when such a trouble occurs, cooling is performed for a short period of time, and moreover the amount of the non-coagulated melt leaked out is small. However, in the case of the apparatus for pulling a large-diameter single crystal ingot, when such a trouble occurs, it takes time for cooling, and once the silicon melt is leaked out, a large amount of the silicon melt flows out to a bottom portion of the apparatus, which causes significant damage.

The crucible made of the C/C composite prepared by using the filament winding process as described in the above-mentioned publication JP-A-10-152391 or JP-A-11-60373 has extremely high strength because of existence of a large number of carbon fibers wound in a direction parallel to a circumferential direction thereof, so that this crucible is suitable for a large-size graphite crucible. However, when the above-described trouble occurs, the silicon melt expands at the time of its coagulation. Accordingly, this acts as the function of breaking the carbon fibers aligned in the circumferential direction, so that a crack in the crucible made of the C/C composite due to the breakage of the carbon fibers may occur.

Further, also in the crucible prepared by adhering the carbon fiber cloth as described in the above-mentioned publication JP-A-10-245275, a large number of carbon fibers aligned in the circumferential direction exist. Accordingly, a crack in the crucible made of the C/C composite due to tension applied in the circumferential direction may occur similarly to the above.

Furthermore, in a production process of the crucible made of the C/C composite described in the above-mentioned publications, the carbon fibers are wound on or the carbon fiber cloth is adhered to the forming die to forming a shape, a matrix precursor such as a resin is impregnated in the carbon fibers or the carbon fiber cloth, and heat curing and burning carbonization are performed together with the forming die, followed by releasing from the forming die.

In these steps, strong tension is also applied to the carbon fibers due to the difference in the thermal expansion coefficient between the forming die and the crucible made of the C/C composite, which may cause the breakage of the carbon fiber.

### SUMMARY OF THE INTENTION

The present invention has been made in view of the above-mentioned problems, and an object of the present invention is to provide a crucible holding member for holding a quartz crucible used in a silicon single crystal pulling apparatus, which is stable in shape even when strong tension acts in the circumferential direction, while securing sufficient strength.

According to aspects of the present invention, there is provided a crucible holding member for holding a quartz crucible for containing a silicon melt, the crucible holding member includes: a mesh body formed by weaving a plurality of strands, each including a plurality of carbon fibers; and a matrix filled in the interstices between the carbon fiber. The mesh body has a triaxial weave structure including: a plurality of longitudinal strands aligned in a same plane as a central axis of the mesh body; a plurality of first strands aligned in a first direction inclined at a first angle with respect to the central axis; and a plurality of second strands aligned in a second direction inclined at second angle same as the first angle with respect to the central axis. The first direction is opposite to the second direction with respect to the central axis.

According to the configuration as described above, a triaxial weave structure including longitudinal strands aligned in the same plane as a central axis and strands aligned diagonally to the central axis, so that it can secure very high strength. Further, even when such force that expands in the circumferential direction acts on the crucible holding member, lattices of the triaxial weave are distorted to be enlarged in the circumferential direction, thereby being capable of absorbing expansion in the circumferential direction. Therefore, the case is not likely to occur, in which the entire shape of the crucible holding member is largely lost. Accordingly, the crucible holding member excellent in shape stability can be provided while securing high strength.

Further, according to the configuration as described above, the rigidity in the circumferential direction of each part can be changed or the rigidity in the circumferential direction can be changed depending on the usage by changing the angle of inclination of the strands diagonally aligned.

### BRIEF DESCRIPTION OF THE DRAWING

The above and other aspects of the present invention will become more apparent and more readily appreciated from the following description of exemplary embodiments of the present invention taken in conjunction with the attached drawings, in which:

Fig. 1 is a cross-sectional view showing a silicon single crystal pulling apparatus using a crucible holding member according to exemplary embodiments of the present invention;

Figs. 2A and 2B are a perspective view and a plan view, respectively, showing a triaxial weave mesh body according to an exemplary embodiment of the present invention;

Fig. 3 is a flow chart showing a production process of a crucible holding member according to the exemplary embodiment;

Fig. 4 is a schematic view showing one example of a production method of a crucible holding member according to the exemplary embodiment;

Fig. 5 is a plan view showing a mesh body according to another exemplary embodiment of the present invention;

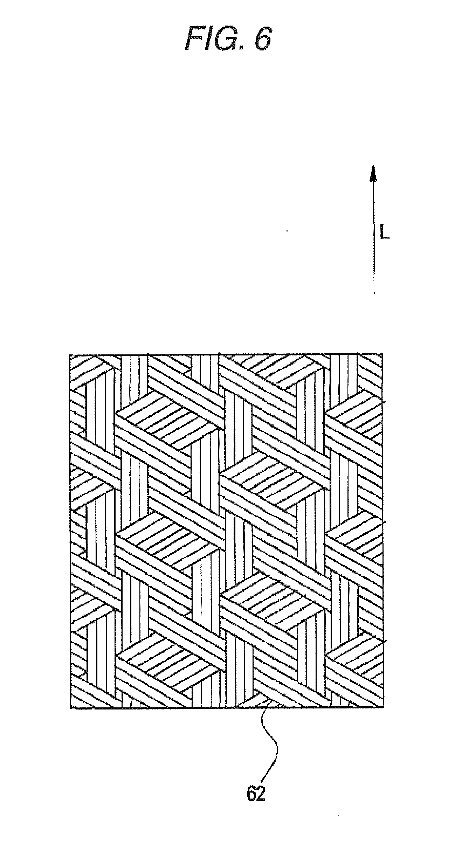

Fig. 6 is a plan view showing a mesh body according to a still another exemplary embodiment;

Fig. 7 shows the analysis results of stress distribution of a crucible holding member according to Example 1; and

Fig. 8 shows the analysis results of stress distribution of a crucible holding member according to Comparative Example 1.

### DETAILED DESCRIPTION

Exemplary embodiments of crucible holding members according to the present invention will be described in detail with reference to the accompanying drawings.

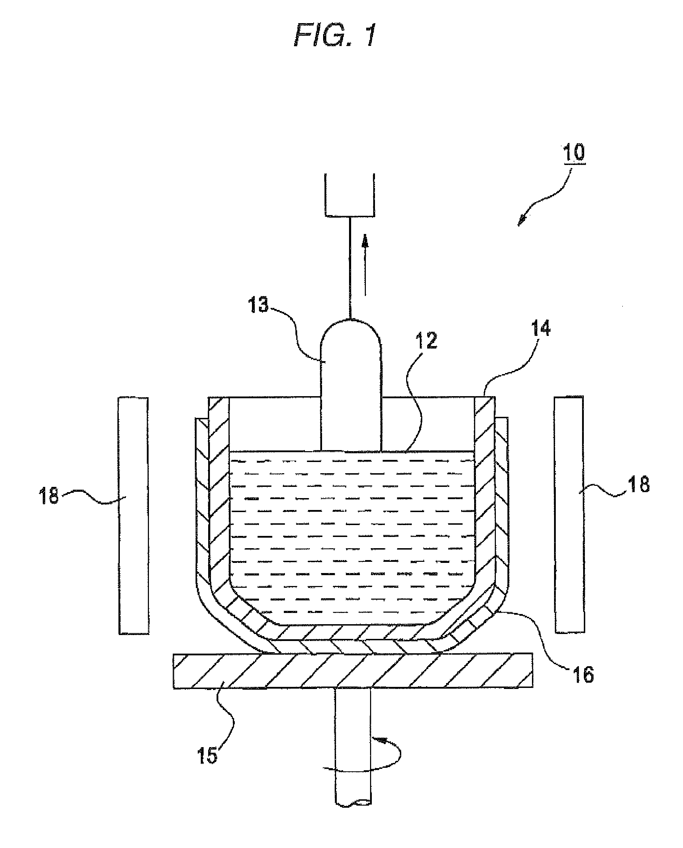

Fig. 1 shows a silicon single crystal pulling apparatus 10 according to an exemplary embodiment of the present invention. In the silicon single crystal pulling apparatus 10 shown in Fig. 1, a quartz crucible 14 for containing a silicon melt 12 and a crucible holding member 16 for holding an outer peripheral surface of the quartz crucible 14 in a state that the quartz crucible 14 is surrounded from the outside are placed on a support 15. A heater 18 is arranged around the periphery of the crucible holding member 16, and an ingot 13 is pulled up while heating the silicon melt 12 through the quartz crucible 14 and the crucible holding member 16 by the heater 18, thereby producing a silicon single crystal.

The crucible holding member 16 includes a mesh body formed of carbon fibers and a matrix filled in the interstices between the carbon fibers.

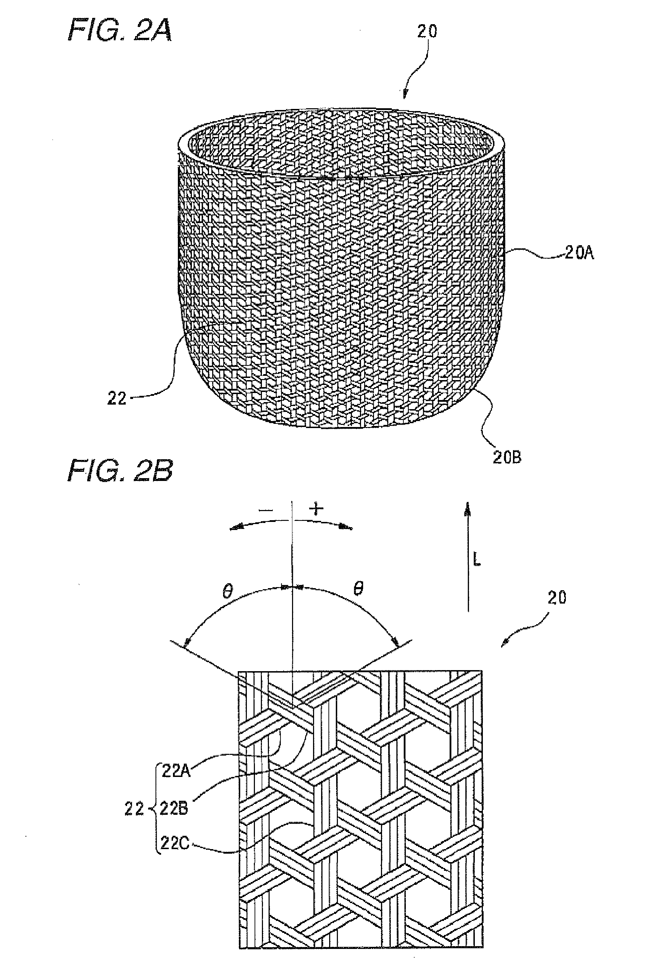

The mesh body according to this exemplary embodiment is shown in Figs. 2A and 2B. The mesh body 20 shown in Figs. 2A and 2B has a substantially basket-like form having a closed-end at bottom. Specifically the mesh body 20 includes a substantially cylindrical body portion 20A and a bowl-shaped bottom portion 20B. This mesh body 20 is formed by triaxial weaving, using ribbon-like strands 22 each obtained by bundling a plurality of carbon fibers as plaited threads. That is, the mesh body 20 has a triaxial weave structure comprising first strands 22A aligned at as angle of inclination of +θ (0<θ<90 degree) with respect to a central axis L of the mesh body 20, second strands 22B aligned at an angle of inclination of -θ, and longitudinal strands 22C aligned in the same plane as the central axis L, as shown in Fig. 2B. In other words, the first strands 22A are aligned in a first direction at a first angle with respect to the central axis L, the second strands 22B are aligned at a second angle same as the first angle with respect to the central axis L and the first direction is opposite to the second direction with respect to the central axis L.

This mesh body 20 can secure high strength because the first strands 22A, the second strands 22B and longitudinal strands 22C are braided in a braid form to have the triaxial structure. Accordingly, the crucible holding member according to this exemplary embodiment can firmly hold even a quartz crucible having heavy weight, so that there can be provided the crucible holding member suitable for a large-size silicon single crystal pulling apparatus.

Moreover, the first strands 22A and the second strands 22B are inclined with respect to the central axis L of the mesh body 20, and not aligned in a direction perpendicular to the central axis (that is, in the circumferential direction of the mesh body 20), so that there is obtained a structure in which the rigidity in the circumferential direction is low. For this reason, even when such force that expands in the circumferential direction acts on the crucible holding member 16 due to the cause as described above, lattices of the triaxial weave are distorted to deform, whereby the mesh body 20 can be enlarged in the width direction to be capable of absorbing expansion in the width direction. Accordingly, the breakage of the carbon fibers is not likely to occur, and the shape is not largely lost, so that the crucible holding member is excellent in shape stability.

Further, in the mesh body 20, the angle of inclination θ of the first strands 22A and the second strands 22B with respect to the central axis L can be appropriately changed, depending on the rigidity required for each part of the crucible holding member 16. The rigidity in the circumferential direction of the mesh body 20 can be adjusted by changing the angle of inclination θ, so that the rigidity in the circumferential direction can be changed depending on the usage or according to each part of the mesh body 20. In other words, the first and second angles vary according to a part of the hollow mesh body.

For example, at an upper side of the crucible holding member 16, an applied load caused by the silicon melt 12 is little, and when the silicon melt coagulates in the initiation of pulling, the upper side directly receives volume expansion of the silicon melt 12, so that it is preferred that the angle of inclination θ is decreased in order to decrease the rigidity. On the other hand, since the bottom portion of the quartz crucible is rounded, a lower side of the crucible holding member 16 is not likely to receive the volume expansion directly, when the load caused by the silicon melt is large and the silicon melt coagulates in the initiation of pulling. Accordingly, it is referred that the angle of inclination θ is increased so as to increase the rigidity.

In the case where the angle of inclination θ is decreased, even when the expansion of the silicon melt 12 occurs to extend in a lateral direction (in the circumferential direction), it is easy to follow the extension in the lateral direction, because the degree of shrinkage in a longitudinal direction (in a height direction) to the extension in the lateral direction is small. However, in the case where the angle of inclination θ is increased, when the expansion of the silicon melt 12 occurs to extend in the lateral direction, it is hard to follow the extension in the lateral direction, resulting in the application of strong force to the respective strands 22 because the degree of shrinkage in the longitudinal direction to the extension in the lateral direction increases. Accordingly, the first strands 22A or the second strands 22B are broken, or the longitudinal strands 22C become easy to buckle.

The strands 22 are each formed by bundling about tens of thousands of carbon fibers. As the carbon fibers constituting the strands 22, there can be used pitch-based carbon fibers, PAN-based carbon fibers or the like. The carbon fibers constituting the first strands 22A, the second strands 22B and the longitudinal strands 22C may be the same material or different materials.

The shape of the strands 22 may be a rod form or the like, as well as a ribbon form. Further, if strands subjected to sizing treatment by impregnating them with an epoxy resin or the like are used as the strands 22, appropriate elasticity is obtained to cause easy weaving in an equal cycle even in manually weaving the strands.

If the silicon single crystal pulling apparatus 10 is a large size which can produce a large-diameter ingot, it is preferred that the crucible holding member 16 has low thermal conductivity in an up and down direction so as to give such a temperature gradient that the temperature of an upper potion becomes high and that of a lower portion becomes low in the silicon melt 12 in order to reduce convection flow of the silicon melt 12. For example, the thermal conductivity of the longitudinal strands may be lower than that of the first and second strands. If the silicon single crystal pulling apparatus 10 is a large size, the time taken for pulling becomes relatively long, resulting in containing the silicon melt 12 in the quartz crucible 14 for a long period of time. If the silicon melt 12 is placed in the quartz crucible 14 for a long period of time, the silicon melt 12 is liable to be contaminated with oxygen from the quartz crucible 14. However, the contamination with oxygen can be prevented by reducing convection flow of the silicon melt 12 as much as possible.

The carbon fibers, which form the strands having low thermal conductivity, include, for example, general carbonaceous carbon fibers (to graphitic carbon fibers) and the like.

A matrix precursor for filling the carbon fibers constituting the strand may be any, as long as it can form a carbonaceous or graphitic matrix by burning. As the matrix precursor carbonized or graphitized by burning, there can be used pitch obtained from petroleum, coal or the like, as well as a thermosetting resin having a high carbonization yield such as a COPNA resin, a phenol resin, a furan resin or a polyimide resin. Further, the matrix can also be formed by Chemical Vapor Infiltration (CVI) of pyrolytic carbon, SiC or the like.

In addition, if the mesh size of the crucible holding member 16 is large, the quartz crucible 14 inserted in the crucible holding member 16 is softened and quarts crucible 14 may enter into the meshes to cause difficulty in removal. In order to prevent this, it is advantageous to provide a carbonaceous or graphitic sheet such as an expanded graphite sheet or a carbon fiber papermaking sheet between the crucible holding member 16 and the quartz crucible 14.

Further, if such a carbonaceous or graphitic sheet is provided, the quartz crucible 14 and the crucible holding member 16 do not directly contact with each other, so that the deterioration of the crucible holding member 16 caused by a reaction with the quartz crucible 14 is not likely to occur. Accordingly, the crucible holding member can be repeatedly used by exchanging only the carbonaceous or graphitic sheet.

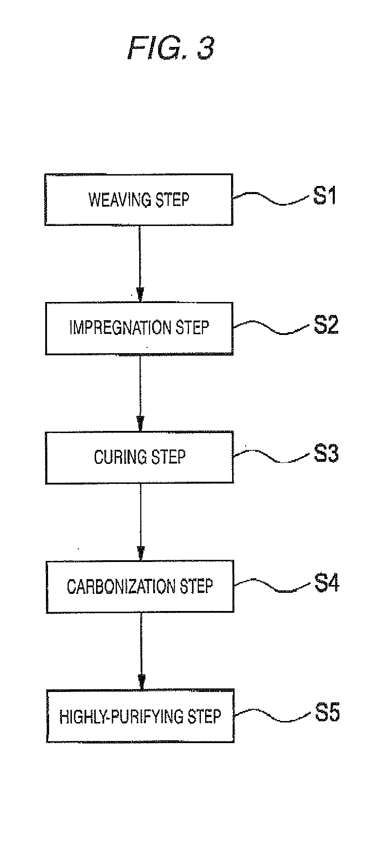

One example of a method for producing the crucible holding member according to this exemplary embodiment will be described below with reference to Fig. 3. The crucible holding member according to this exemplary embodiment can be produced by the following five steps, namely a weaving step S1, an impregnation step S2, a curing step S3, a carbonization step S4 and a highly-purifying step S5.

A) Weaving Step S 1

First, a cylindrical forming die for forming a triaxial weave mesh body 20 (Fig. 2) is prepared. Although the material of the forming die is not particularly limited, the forming die made of graphite is preferably used so as not to be carburized in the later carbonization step and the like. If the large-size mesh body is to be formed, the large-size forming die may be formed by combining a plurality of graphite material pieces by means of an adhesive or the like. In this case, it is preferred that a COPNA resin is used as the adhesive because the use of the COPNA resin makes it possible to maintain adhesive force even after subjection to the carbonization step. Further, if a hollow forming die is used, it is light in weight and easy to handle.

In order to make it easy to perform mold release, it is advantageous to previously wrap a mold releasing film having liquid impermeability and heat resistance around the periphery of the forming die. The material of the film is not particularly limited, as long as it has liquid impermeability and heat resistance at about a curing temperature. Examples thereof include polyethylene terephthalate, a silicone resin, polytetrafluoroethylene, cellophane, polyvinyl chloride, polyvinylidene chloride and the like. If the mold releasing film is wrapped, it does not decompose until curing and decomposes or carbonizes until carbonization, resulting in easy mold release.

Ribbon-like strands are each formed by bundling a plurality of carbon fibers, and the stands are woven along an outer periphery of the forming die by a three-dimensional braiding method, thereby being able to form the cylindrical mesh body. The formation of the mesh body by the three-dimensional braiding method can be performed by a related-art method.

A commercially available automatic loom (for example, TWM-32C, TRI-AX, manufactured by Howa Machinery, Ltd.) can be utilized for weaving the strands. If the automatic loom is hard to obtain in markets, the cylindrical mesh body can be manually formed just like the formation of braid.

Further, the mesh body may be formed by preparing a triaxial fabric in which the strands are woven in a planar form, rounding it into a cylindrical form around the forming die and bonding it with an adhesive or the like to form the cylindrical portion of the mesh body, and further, adhering thereto the bottom portion produced by the three-dimensional braiding method.

If the mesh body is prepared using the strands subjected to sizing treatment using an epoxy resin or the like in large amount, and if it becomes difficult to impregnate the mesh body with a resin as a matrix precursor in the subsequent step, defatting treatment may be performed after the formation of the mesh body in order to remove the sizing material such as the epoxy resin. The defatting treatment is usually performed by heating at about 150 to 400°C under a nonoxidative atmosphere. It is advantageous that this defatting treatment is performed only when the strands subjected to the sizing treatment using the epoxy resin or the like in large amounts are used.

B) Impregnation Step S2

The mesh body formed in the weaving step S1 is immersed in the uncured matrix precursor to form an original material in which the mesh body is impregnated with the matrix precursor.

The impregnation may be performed either at normal pressure or under increased pressure. If the carbon fibers are thin and wettability with the matrix precursor to be impregnated is poor, the impregnation under increased pressure is effective. Further, if the matrix precursor has sufficient wettablility with the carbon fibers, the matrix precursor can be sufficiently impregnated in the strands only by coating or spraying.

In addition, if vacuuming is performed before the impregnation, voids are not likely to remain in the strands. Accordingly, the homogeneous original material can be obtained.

C) Curing Step S3

Then, the mesh body (original material) impregnated with the matrix precursor is heated to be cured. Although the curing temperature can be appropriately set depending on the kind of matrix precursor and the like, it is set at a temperature at which gelation reaction associated with the curing severely occurs (roughly about 100°C to 150°C). It may be important to slow down the increase rate of temperature in the vicinity of a predetermined temperature to sufficiently vent a generated gas so as to make it possible to sufficiently diffuse the gas.

D) Carbonization Sep S4

Organic materials contained in the original material obtained in the curing step S3 are carbonized to obtain a crucible holding member mainly composed of carbon. The treatment temperature in the carbonization step is preferably at least about 600°C (a temperature at which the discharge of the organic gas starts to subside), and more preferably 900°C (a temperature at which contraction in size and gas generation subside) or higher.

Mold release is preferably performed after the carbonization. The carbonization together with the forming die results in less collapse in shape, which does not require after processing for arranging the shape. When the after processing can be omitted, the carbon fibers are not cut, and the crucible holding member having no splinter can be provided. If the curing is fully performed in the prior step, the mold release may be performed before the carbonization step.

If the carbonization step is performed without releasing the forming die, this step can be performed subsequent to the above-described curing step S3 without lowering the temperature. That is, the curing step S3 can be performed as a part of the carbonization step S4.

E) Highly-Purifying Step S5

The crucible holding member obtained by the method of the carbonization step S4 is subjected to highly-purifying treatment to remove impurities. The highly-purifying treatment can be performed by a related-art method. Specifically, it can be performed by heat treatment in an atmosphere gas such as a halogen gas or a halogenated hydrocarbon at 1,500°C to 3,000°C for 1 hour or more.

In the above-described production example, the mesh body is impregnated with the matrix precursor after the preparation of the mesh body. However, the strands are previously impregnated with the matrix precursor, and the mesh body can also be woven using the strands impregnated with the matrix. That is, the crucible holding member can be produced in the order of the impregnation step S2, the weaving step S1, the curing step S3, the carbonization step S4 and the highly-purifying step S5. In any order, it is preferred that the curing step S3 is performed after the impregnation step S2 and the weaving step S1 because the matrix adhered to surfaces of the strands acts as an adhesive among the strands.

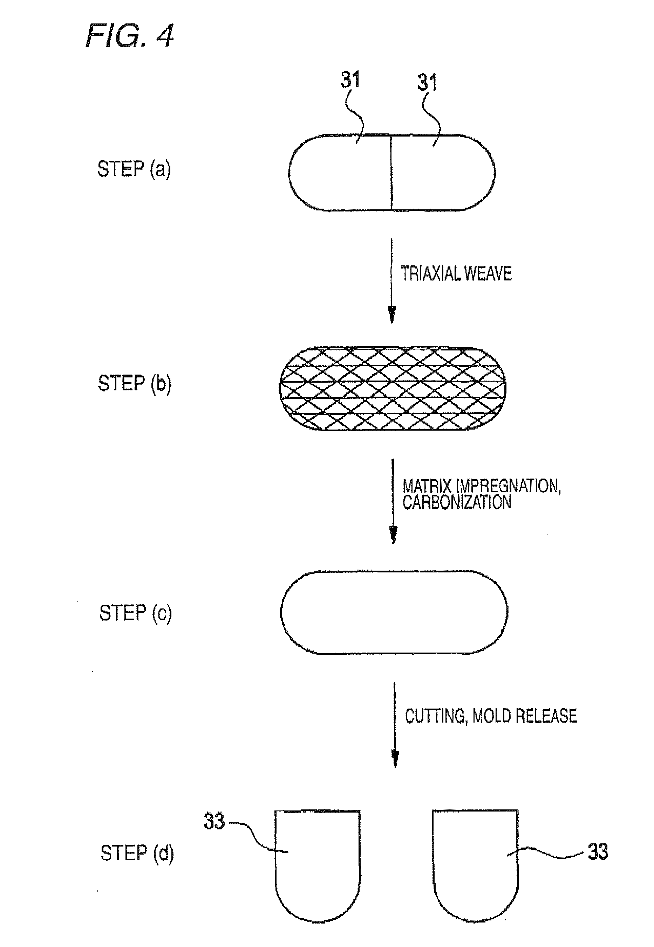

Further, in order to improve production efficiency, the crucible holding member may be produced by a method shown in Fig. 4. In the method shown in Fig. 4,(a) two bowl-shaped forming dies 31 are prepared and joined with each other at opening face sides, and (b) a substantially cylindrical triaxial fabric 32 is produced by triaxial weave around the joined bowl-shaped forming dies 31. Further, (c) the impregnation step of the matrix material and the carbonization step thereof are performed, and then, (d) mold release is performed after cutting into two parts at a central portion, thereby being able to produce two crucible holding members 33 at once. If the crucible holding members are produced in such a manner, the crucible holding member can be efficiently produced. In addition, fray at an opening is hard to occur in the course from the impregnation of the matrix precursor to the carbonization thereof because the opening can be narrowed.

While the present invention has been shown and described with reference to certain exemplary embodiments thereof, it will be understood by those skilled in the art that various changes in form and details may be made therein without departing from the spirit and scope of the invention as defied by the appended claims.

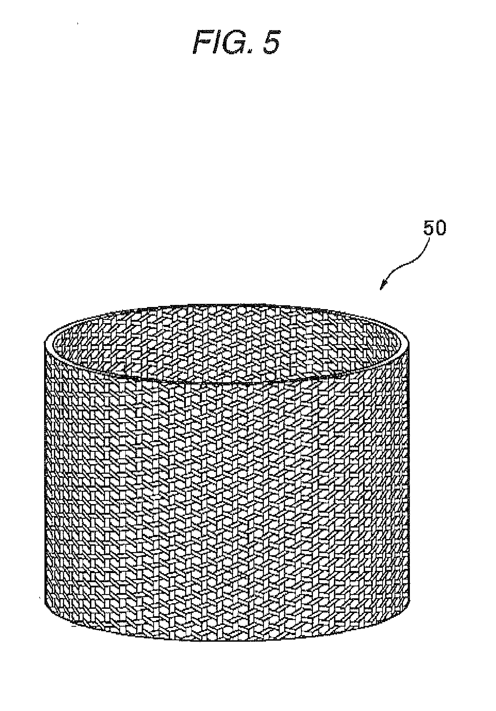

For example, in the above-described exemplary embodiment, the substantially basket-like crucible holding member 16 is shown. However, the crucible holding member according to the present invention is not limited to the basket form, and can be configured by a substantially cylindrical mesh body 50 shown in Fig. 5. If the mesh body 50 has the substantially cylindrical form, changes in external form are small from the start of weaving to the end of weaving, so that changes in the ratio of the outer diameter of a portion which is being woven to the outer diameter of a loom are small. Accordingly, it is advantageous that the loom requires no mechanism for following up the changes in outer diameter.

In addition, the shape of the crucible holding member 16 may be a taper-shaped conical trapezoidal form or a form in which a bottom portion of a cylindrical form is narrowed. In the case of the cylindrical form, the longitudinal strands 22C are parallel to the central axis. However, in the case of the taper-shaped conical trapezoidal form or the form in which a bottom portion of a cylindrical form is narrowed, the longitudinal strands become substantially parallel to the central axis. In each case, the central axis and the individual longitudinal strands exist in the same plane.

Further, in the above-described exemplary embodiment, there is described a triaxial weave configuration in which the strands are diagonally aligned one by one. However, the mesh body may have a triaxial weave structure in which two or more strands 62 are diagonally aligned.

[Examples]

Examples of more specific structures of crucible holding members according to the present invention and production methods thereof will be described with reference to the following examples. The present invention is not limited to these production methods, and any method may be used, as long as the crucible holding members according to the present invention can be obtained.

<Example 1>

First, a forming die for producing a mesh body is prepared, Six side plates made of graphite (600 mm wide, 850 mm long and 200 mm thick) are prepared. Corners of the respective side plates are planed to an angle of 60 degree, and the side plates are bonded to one another by using an adhesive for graphite material (COPNA resin) to form a hollow hexagonal cylinder. Next, two bottom plates made of graphite (736 mm wide, 1,700 mm long and 200 mm thick) are prepared, and bonded to an end face of the follow hexagonal cylinder by using an adhesive for graphite material (COPNA resin) to form a crude forming die. Then, an outer peripheral surface of a body portion of this crude forming die is ground to a cylindrical form, and an outer peripheral surface of a bottom portion is ground to a bowl form to produce a forming die (1,400 mm diameter and 600 mm high).

Next, using 140 ribbon-like strands for each of the first, second and longitudinal strands, a triaxial weave mesh body is manually formed on an outer peripheral surface of the forming die. Each of the strands is composed of 24,000 carbon filaments (manufactured by Toray Industries, Inc., trade name: T800S24K).

The mesh body produced above is impregnated with a phenol resin forming material (manufactured by Asahi Organic Chemicals Industry Co., Ltd., KL-4000) as a matrix precursor, then, elevated in temperature to 200°C at a rate of temperature increase of 2°C/hour in a drier equipped with an exhaust system, and allowed to stand as it is for 3 hours to cure it.

<Example 2>

A mesh body is produced using a cylindrical forming die in place of the forming die of the above-described Example 1. The cylindrical forming die is produced by the following method, First, six side plates made of graphite (600 mm wide, 850 mm long and 200 mm thick) are prepared. Corners of the respective side plates are planed to an angle of 60 degree, and the side plates are bonded to one another by musing an adhesive for graphite material (COPNA resin) to form a hollow hexagonal cylindrical crude forming die. Then, an outer peripheral surface of this crude forming die is ground to a cylindrical form to produce the forming die (1,400 mm diameter and 600 mm high).

Next, using 140 ribbon-like strands for each of the first, second and longitudinal strands, a triaxial weave mesh body is manually formed on an outer peripheral surface of the forming die. Each of the strands is composed of 24,000 carbon filaments (manufactured by Toray Industries, Inc., trade name: T800S24K).

Hereinafter following the same procedure as in Example 1, a cylindrical crucible holding member is obtained.

<Comparative Example 1>

A forming die is produced in the same manner as in Example 1, and covered with a plain weave cloth formed using the same strands as in Example 1. In that case, the strands are arranged so as to be aligned in a longitudinal direction and a circumferential direction. Further, impregnation with the phenol resin forming material, curing, carbonization and highly-purifying treatment are performed in the same manner as in Example 1. A crucible holding member thus obtained has no strands aligned diagonally which exist in Example 1 described above, and has strands aligned laterally (hereinafter referred to as lateral strands).

<Test Example 1>

A state of stress distribution at the time when strain was applied in a circumferential direction to the triaxial weave crucible holding member obtained as described in Example 1 was modeled with Solid Works 2007 (registered trademark) manufactured by Solid Works Corporation), and static analysis was performed with a Cosmos Works (registered trademark) manufactured by Structural Research & Analysis Corporation. Taking the width of the strand as 10 mm, the thickness thereof as 2 mm, and an overlapped portion of the triaxial weave as being fixed with a 3 mm diameter pin, a minimum element unit of the triaxial weave was modeled. The strain amount in the lateral direction was 0.3%, the elastic modulus of the strand was 400 GPa, and Poisson's ratio was 0.2.

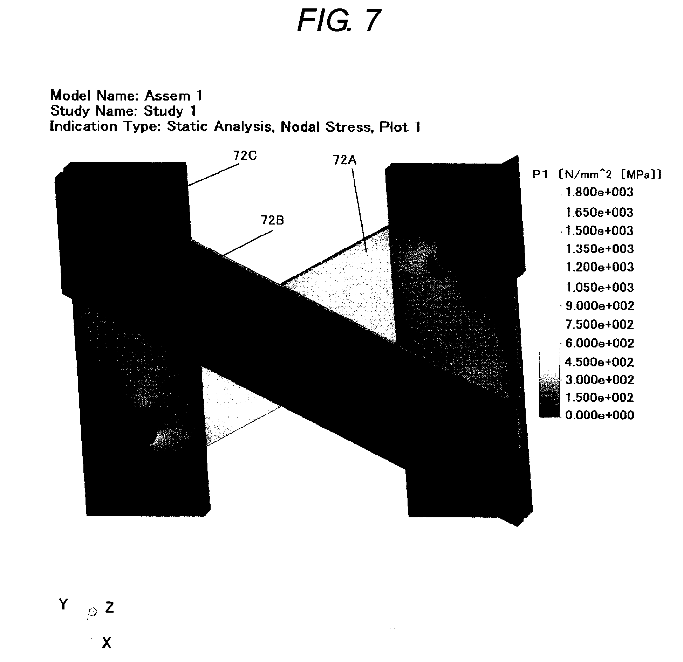

The result of stress analyzed under the above-mentioned conditions is shown in Fig. 7. It is found that the strain applied in the lateral direction is also transmitted to the longitudinal strands 72C through the first strands 72A and the second strands 72B aligned diagonally, resulting in uniform application of the stress as a whole.

Also for the crucible holding member of Example 2, similar result was obtained.

<Test Example 2>

For a state of stress distribution at the time when strain was applied in a circumferential direction to a body portion of the crucible holding member including the plain weave mesh body of the longitudinal strands (in the height direction) and the lateral strands (in the circumferential direction), which was obtained as described in Comparative Example 1, static analysis was performed in the same manner as in Test Example 1, Taking the width of the strand as 10 mm, the thickness thereof as 2 mm, and an overlapped portion of the triaxial weave as being fixed with a 3 mm diameter pin, a minimum element unit of the triaxial weave was modeled. The strain amount in the lateral direction was 0.3%, the elastic modulus of the strand was 400 GPa, and Poisson's ratio was 0.2.

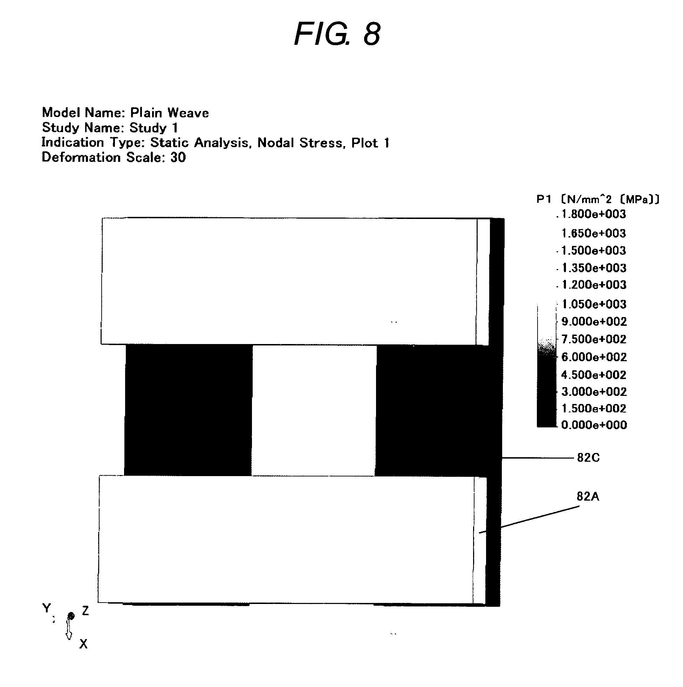

The result of stress analyzed under the above-described conditions is shown in Fig. 8. It is found that the strain applied in the lateral direction is applied to only the lateral strands 82A and scarcely transmitted to the longitudinal strands 82C. It is therefore conceivable that large stress (tension) is applied to the lateral strands 82A, which causes easy breakage.

## Claims

1. A crucible holding member for holding a quartz crucible for containing a silicon melt, the crucible holding member comprising:
a mesh body formed by weaving a plurality of strands, each including a plurality of carbon fibers; and
a matrix filled in the interstices between the carbon fibers,
wherein the mesh body has a triaxial weave structure including:
a plurality of longitudinal strands aligned in a same plane as a central axis of the mesh body;
a plurality of first strands aligned in a first direction inclined at a first angle with respect to the central axis; and
a plurality of second strands aligned in a second direction inclined at second angle same as the first angle with respect to the central axis, and
wherein the first direction is opposite to the second direction with respect to the central axis.

2. The crucible holding member according to claim 1,
wherein the strands of the mesh body does not include strands aligned in a direction perpendicular to the central axis.

3. The crucible holding member according to claim 1 or 2,
wherein the mesh body has a substantially basket-tike form having a closed-end bottom.

4. The crucible holding member according to claim 1,
wherein the first angle and the second angle vary according to a part of the hollow mesh body.

5. The crucible holding member according to claim 4,
wherein the first and second angles at an upper part of the mesh body are smaller than the first and second angles at a lower part of the mesh body.

6. A method for producing a crucible holding member, the method comprising:
forming a mesh body having a basket-like form having a closed-end bottom with a central axis by weaving a plurality of strands, each of the strands including a plurality of carbon fibers;
impregnating the mesh body with a matrix precursor;
curing the mesh body impregnated with the matrix precursor by heating; and
carbonizing the cured mesh body,
wherein the mesh body has a triaxial weave structure including;
a plurality of longitudinal strands aligned in a same plane as the central axis;
a plurality of first strands aligned in a first direction inclined at a first angle with respect to the central axis; and
a plurality of second strands aligned in a second direction inclined at second angle same as the first angle with respect to the central axis, and
wherein the first direction is opposite to the second direction with respect to the central axis.

7. The method according to claim 6,
wherein the first angle and the second angle are changed according to a part of the mesh body.

8. The method according to claim 7,
wherein the first and second angles at an upper part of the mesh body are smaller than the first and second angles at a lower part of the mesh body.
